# EUROPEAN PATENT SPECIFICATION

(11) **EP 0 323 505 B1**
(45) Date of publication and mention of the grant of the patent: **26.01.1994**
(21) Application number: 88906324.4
(22) Date of filing: 09.06.1988
(51) Int. Cl.: C25D 1/04, C25D 17/00

(54) **CATHODE SURFACE TREATMENT FOR ELECTROFORMING METALLIC FOIL OR STRIP**
KATHODISCHE OBERFLÄCHENBEHANDLUNG ZUR BILDUNG VON METALLISCHEN FOLIEN ODER BÄNDERN
TRAITEMENT DE SURFACE CATHODIQUE POUR L'ELECTROFORMAGE D'UNE BANDE OU FEUILLE METALLIQUE

(30) Priority: 23.06.1987 US 65452
(43) Date of publication of application: 12.07.1989
(73) Proprietor: GOULD ELECTRONICS INC., Eastlake, Ohio 44095-4001 (US)
(72) Inventor: POLAN, Ned, W., Madison, CT 06433 (US)
(74) Representative: Crisp, David Norman
(86) International application number: US8801898
(87) International publication number: WO8810327

(56) References cited:
- GB-A- 1 548 550
- US-A- 1 417 464
- US-A- 1 978 037
- US-A- 2 433 441
- US-A- 2 944 954
- US-A- 4 073 699
- US-A- 4 529 486

## Description

The present invention relates to a process and apparatus for forming electrodeposited metal foil or strip having superior, substantially isotropic mechanical properties, and to the foil or strip so formed.

Electroformed or electrodeposited metal foils such as E-D copper foil are used extensively in the electronic and electrical industries. One typical application for electrodeposited foil is in printed circuits. As the requirements for printed circuits become more severe because of greater design sophistication, so have the requirements imposed upon the copper foil producers. Printed circuit manufacturers desire the foil to be substantially pore free and to possess superior mechanical properties. The techniques and equipment used to make these foils must therefore be capable of producing foil with the desired quality.

As can be seen from U.S. Patent US-A-1,417,464 and US-A-1,543,861, the basic electroforming technology is old and well known. Generally, electrodeposited metal foil is formed by immersing an anode and a moving plating surface in an electrolyte containing a concentration of metal values to be plated and applying an electrical current between the anode and the plating surface so as to deposit a relatively smooth layer of metal on the surface. As the plating surface and the newly plated foil emerge from the electrolyte, the foil is peeled from the plating surface and coiled onto a take-up reel.

It has been long recognized that electrodeposited foil quality can be improved by using a rotating chromium plated steel drum to produce electrodeposited copper foil.

Techniques such as polishing of the plating surface prior to immersion in the plating electrolyte have been used in an attempt to provide better quality foil. In these techniques, a driven brush is generally used to remove foreign matter and oxides from the plating surface. In order to provide the freshest possible surface, the brush is typically positioned close to the point where the moving plating surface enters the electrolyte. US-A-1,952,762, US-A-2,335,776, US-A-2,865,830, and US-A-2,944,954 to Yeck and U.K. Patents GB-A-1,543,301 and GB-A-1,548,550 illustrate electroforming systems having drum polishing rolls. US-A-1,978,037 illustrates an electroforming apparatus wherein a rubber-abrasive belt is used in lieu of a roll to polish the plating surface.

Such techniques provide a circumferential polishing of the moving plating surface whether a drum or a belt. The result is an anisotropic distribution of polishing marks or scratches. Such scratches extend in a generally longitudinal direction around the circumference of the drum. "Longitudinal" as the term is used herein refers to the direction of movement of the plating surface. If the polishing roll or brush merely rotates in a stationary position, the polishing marks lie in the longitudinal direction parallel to one another. This results in a coarser surface finish transversely of the plating surface as compared to the longitudinal direction. The result of plating such a surface having anisotropic surface scratches or marks is that the foil which is produced thereby also has anisotropic properties and, in particular, the transverse tensile elongation properties of the foil are markedly poorer than the longitudinal properties. In summary, such circumferential polishing produces foil which can exhibit mechanical properties which are significantly poorer in one direction than another. This disparity in mechanical properties is believed to be the result of the circumferential polishing done on the plating surfaces by the polishing rolls or belts.

Systems using a moving endless belt in lieu of a rotating drum type cathode have been used in an attempt to produce better quality foil. In these systems, the electrodeposited foil is formed either on the belt itself or on a fresh layer formed on a surface of the belt. Preparation of the plating or belt surface often includes a cleaning and/or roughening operation. For example, in US-A-2,433,441, the endless belt is subjected to a polishing operation after the plated foil has been removed. While this polishing operation uses a plurality of reciprocatory polishing heads, it is intended only to remove contaminants and other impurities from the surface of the belt. It does not appear intended to abrade the surface of the belt. US-A-4,073,699 to Hutkin illustrates a belt plating system in which the endless belt is subjected to a roughening treatment in preparation for subsequent plating.

According to one aspect, the invention provides an electrodeposited metal foil suitable for use in electronic and electrical applications, said foil comprising a surface roughness at one of its major surfaces as a result of its electrodeposition,
characterised in that the surface roughness in the longitudinal direction of said foil differs by at most 20% from the surface roughness in the transverse direction of said foil, and in that the tensile elongation properties of said foil are substantially isotropic.

According to another aspect, the invention provides a process for providing such an electrodeposited metal foil comprising:
polishing a plating surface for forming electrodeposited metal foil in a generally random fashion to provide a surface roughness in a longitudinal direction which differs by at most 20% from the surface roughness of said surface in a transverse direction; and
electrodepositing metal onto said plating surface.

According to yet another aspect the invention provides an apparatus for forming electrodeposited foil having substantially isotropic mechanical properties, comprising:
a tank for holding an electrolyte containing a concentration of metal ions;
a first electrode mounted in said tank so as to be at least partially immersed in said electrolyte;
a second electrode mounted in said tank so as to form an interelectrode gap with said first electrode;
said second electrode having a plating surface with a substantially isotropic surface finish;
means for flowing said electrolyte through said interelectrode gap at a desired flow rate; and
means for applying a current across said electrodes so as to form said foil having said substantially isotropic tensile elongation properties on said plating surface.

This invention provides a system capable of forming substantially pore free electrodeposited metal foil characterized by substantially uniform or isotropic mechanical properties. The electroforming apparatus of the present invention comprises: an electrochemical cell; an electrolyte containing a concentration of metal values to be plated; an anode at least partially immersed in the electrolyte; and a living plating surface having an isotropic surface finish. The moving plating surface may be a rotating drum cathode or an endless belt. The desired isotropic surface finish is preferably imparted to the plating surface by using a series of polishing steps with each step using an abrasive device having sequentially finer grit sizes generally in the range of from about 29 to about 17 micrometres (about 320 to about 600 grit). While it is preferred that each step be performed so as to impart a random finish to the plating surface, only the last step in the series needs to impart such a finish to the plating surface.

Alternatively, though less preferred, it has been found that foil having improved mechanical properties in an isotropic sense can be produced by imparting to the plating a surface finish which is equally distributed in both a first longitudinal direction parallel to the direction of travel of the plating surface and a second direction transverse to the first direction.

The present invention can thus provide:
(a) an electrodeposited metal foil having substantially isotropic mechanical properties;
(b) an electrodeposited metal foil as above which is also substantially pore free; and
(c) an electrodeposited metal foil as above suitable for use in electronic and electrical applications.

As used herein, the term isotropic refers to substantially uniform properties at least along the longitudinal and transverse axes of the electrodeposited metal foil and generally in all directions of the foil plane. As used herein, the term foil also refers to electroformed metal in strip or bar form.

A preferred electroforming apparatus in accordance with the present invention includes a tank for holding an electrolyte. The tank is preferably formed from an inert material such as lead or stainless steel; although, it may also be formed from a structural material such as concrete which is then lined with a corrosion resistant material such as rubber or polyvinyl chloride.

The apparatus further includes an anode preferably having an arcuate shape and a central perforated zone. The anode may be formed from any suitable electrically conductive, insoluble metal or metal alloy. Typical anode materials include lead, antimony and alloys thereof. If desired, the central perforated zone may be formed from a different material than the rest of the anode. For example, the perforated zone may be formed from a material more resistant to erosion than the material forming the rest of the anode. The anode is described in more detail in U.S. Patent US-A-4,529,486.

The anode may be mounted in the tank in any desired manner using any suitable means (not shown) known in the art. Generally, the anode is mounted in a way which provides a substantially uniform interelectrode gap with the moving plating surface of a drum cathode mounted for rotation about an axis which, typically, is a substantially horizontal axis. Any suitable means known in the art may be used to mount the drum cathode in the tank. Preferably, the cathode is mounted so that about half of it extends beneath the surface of the electrolyte.

The rotating drum cathode may be formed from any suitable electrically conductive metal or metal alloy including but not limited to lead, stainless steel, columbium, tantalum, titanium, chromium and alloys thereof. In a preferred embodiment, the drum cathode comprises a stainless steel drum having a plating surface formed from titanium, columbium, tantalum, or alloys thereof. As will be discussed in more detail hereinafter, the plating surface is preferably characterized by an isotropic surface finish in accordance with this invention. The drum cathode may be rotated by any suitable motor drive system (not shown) known in the art.

The anode and the cathode must be mounted in the tank so that the interelectrode gap is not too wide. If the gap is too wide, there could be a significant IR loss across the gap. Practically, this means that the interelectrode gap should be less than about 50 millimeters. Preferably, the gap is in the range of from about 5 millimeters to about 40 millimeters, most preferably from about 15 millimeters to about 30 millimeters.

The electrolyte in the tank generally comprises an aqueous acidic solution containing a concentration of metal ions to be deposited onto the plating surface. For example, if copper foil is to be formed, the electrolyte would contain a concentration of copper ions. During plating, it is desirable to maintain the electrolyte at a temperature in the range of from about room temperature to about 100°C. To this end, the tank 12 may be provided with any suitable means (not shown) known in the art for maintaining the electrolyte at a desired temperature. For example, a heating/cooling loop not shown may be incorporated into or connected to the tank.

When forming electrodeposited copper foil, a copper sulfate-sulfuric acid electrolyte may be used. It has been found that particularly good quality foil can be formed using an electrolyte at a temperature of about 60°C. At this temperature, the electrolyte contains from about 10 grams/liter to about 320 grams per liter, preferably from about 100 grams/liter to about 300 grams per liter, of copper, generally in the form of copper sulfate. The electrolyte also contains sulfuric acid in a concentration up to that which causes copper to precipitate out as copper sulfate, preferably from about 10 grams per liter to about 100 grams per liter. However, in accordance with this invention, any desired electrolyte can be used.

The apparatus further includes a manifold through which fresh electrolyte is provided in a substantially continuous fashion to the interelectrode gap. The manifold may be mounted in the tank 12 in any desired manner and suitably connected to a source of electrolyte by any desired means.

Typical electrolyte flow rates used with the apparatus of the present invention are in the range of from about 1 meter/second to about 4 m/sec., preferably from about 1 m/sec. to about 2.5 m/sec. Normally, electrolyte will flow through the manifold, through the perforations in the perforated zone of the anode into the interelectrode gap, over the edges of the arcuate anode, and back into the tank. If desired, the manifold may be connected to a pump not shown to create the desired electrolyte flow throughout the cell. If a pump is utilized, any appropriate conventional pump known in the art may be used.

Finally, the apparatus includes a power supply to which the cathode and the anode are electrically connected. The power supply is used to apply an electroplating current having a current density in the range of from about 0.4 Amps/cm² to about 2.0 A/cm², preferably from about 0.5 A/cm² to about 1.5 A/cm², between the anode and the cathode. The power supply may comprise any suitable conventional power supply known in the art for applying either an AC or a DC current.

Substantially isotropic mechanical properties are imparted to the electrodeposited foil by providing the plating surface with a generally isotropic finish. This is accomplished by subjecting the plating surface to a series of sequential polishing steps preferably prior to installing the cathode in the tank. The polishing steps are intended to impart the desired surface finish. One of the advantages of the present technique can be that by performing the plating surface preparation steps prior to cathode installation, one avoids particulate material from the surface preparation steps contaminating the electrolyte. Other advantages associated with the present technique include the creation of a plating surface which maintains good mechanical attachment to the foil during the electroforming process and which does not require frequent surface preparation.

The initial surface preparation or polishing step preferably comprises abrading or grinding the plating surface with, for example, a polishing paper having a grit size in the range of from about 29 to about 17 micrometres (about 320 to about 600 grit). While the surface may be polished in any desired manner during this step, it is preferred to use a generally random motion. This can be done using a manually operated abrading device having an orbital polishing motion or any other suitable means known in the art. Following the initial surface preparation step, one or more additional polishing steps are carried out. Each subsequent polishing step uses an abrading device, such as polishing paper, having a grit size finer than that used in the previous polishing step. Each subsequent polishing step should preferably remove any scratches from the preceding step. These steps preferably also use a generally random motion as by the use of an orbital polishing device.

The final polishing step above in the sequence is the most important because it must impart a finish to the plating surface in which the scratches or polishing marks are substantially randomly oriented. It is important that the plating surface after the final polishing step be neither too smooth nor too rough. If it is too smooth, the foil will fall off prematurely during processing. If it is too coarse, the foil cannot be readily stripped from the plating surface.

While it is preferred to use random motion during the polishing steps, it has also been found that motions which create a surface pattern which is substantially equally distributed in both a first direction parallel to the longitudinal direction of movement of the plating surface and a second direction transverse to the first, may be used to create a surface finish capable of producing foil having near isotropic mechanical properties.

Each of the polishing steps may be performed while the plating surface is either dry or wet. If performed wet, either water or a suitable lubricant such as kerosene or some other lubricant may be applied to the surface prior to polishing.

For printed circuit applications which generally employ copper foil, a mechanical property of particular interest is the ductility of the foil which is generally measured as a tensile elongation. It has been found that prior art foils can have highly anisotropic ductilities. For example, longitudinal tensile elongations measured over a 5.08 cm (2 inch) gauge length have been found to be about 17%; whereas, corresponding transverse tensile elongations have been found at about 11%. A tensile elongation of at least 15% is highly desirable; however, that tensile elongation property of the foil should be isotropic rather than anisotropic. Namely, it should be approximately the same whether the property is measured longitudinally or transversely of the foil. The aforenoted foil comprised a 0.0305 gm/cm² (1 ounce per square foot), class 1, copper foil.

The smooth side of the foil, e.g., the side facing the drum, showed longitudinal markings indicative of circumferential scratches or polishing marks on the drum surface. Quantitative measurement of this surface roughness showed roughness values of from about 0.88 micrometres to about 1.25 micrometres (about 35 to 50 micro inches) in the transverse direction versus roughness values of from about 0.375 micrometres to about 0.88 micrometres (about 15 to about 35 micro inches) in the longitudinal direction. In accordance with this invention, it has been found that anisotropic surface roughness as exhibited by the prior art foil plays a major role in the resultant anisotropic elongation properties.

Accordingly, in accordance with this invention, the surface roughness values for the plating surface are preferably from about 0.125 micrometres to about 1 micrometre (about 5 to about 40 micro inches) and, most preferably, from about 0.125 micrometres to about 0.75 micrometres (about 5 to about 30 micro inches) and those surface roughness values are approximately the same in either the longitudinal or transverse directions on the plating surface and, preferably, in substantially all directions in the plating surface. By substantially the same, it is meant that the surface roughness values in the respective directions are within approximately about 20%, preferably, within about 15% and, most preferably, within about 10% of one another.

To demonstrate the present invention, the following example was performed.

### EXAMPLE

An isotropic surface finish comprising a series of randomly oriented scratch marks was imparted to a 30.5 cm (one foot) diameter, 30.5 cm (one foot) long drum plating surface of titanium using a conventional hand-held orbital sander. The surface was initially polished using 29 micrometres (320 grit) polishing paper. Subsequent polishing steps were performed with finer papers through 23 micrometres (400 grit).

Copper foil of 0.0305 gm/cm² (1 oz/ft²) weight was electroformed on this drum using an apparatus similar to that described in detail above. The electrolyte contained 1.7Molar CuSO₄ and 0.4Molar H₂SO₄ and was maintained at a temperature of 60°C. An electrolyte flow rate of 1.3 meters/second was maintained through the interelectrode gap and a current having a current density of 0.6 Amps/cm² was applied.

Examination of the copper foil revealed an isotropic surface roughness on the smooth or drum side of the foil of from about 0.375 micrometres to about 0.625 micrometres (about 15 to about 25 micro inches) in both the longitudinal and transverse directions. The ductility of the foil was also found to be isotropic and had a high 16% longitudinal elongation and 17% transverse elongation over a 5.08 cm (two inch) gauge length. This superior isotropic ductility is of major importance in the printed circuits which are subject to significant thermal stresses, particularly multilayer circuits.

While the present invention has been described in terms of imparting a certain surface finish to a rotating drum cathode, it should be apparent that the surface finish preparation steps of the present invention could also be used in conjunction with an endless belt type electroforming apparatus where the belt comprises both the cathode and the plating surface.

"Surface roughness" as the term is used herein comprises an average surface roughness for the material and can be readily measured by any conventional profilometer.

## Claims

1. An electrodeposited metal foil suitable for use in electronic and electrical applications, said foil comprising a surface roughness at one of its major surfaces as a result of its electrodeposition,
characterised in that the surface roughness in the longitudinal direction of said foil differs by at most 20% from the surface roughness in the transverse direction of said foil, and in that the tensile elongation properties of said foil are substantially isotropic.

2. The metal foil of claim 1 which is substantially pore free.

3. The metal foil of claim 1 or 2 which is a copper foil suitable for use in a printed circuit board.

4. The metal foil of claim 1, 2 or 3 wherein the surface roughness of said first surface in the longitudinal direction differs by at most 10% from the surface roughness in the transverse direction.

5. The metal foil of any preceding claim wherein the surface roughness of said first major surface in the longitudinal direction is from 0.125 micrometres to 0.75 micrometres (5 to 30 micro inches) and wherein the surface roughness of said first major surface in the transverse direction is from 0.125 micrometres to 0.75 micrometres (5 to 30 micro inches).

6. The metal foil of claim 5 wherein said surface roughnesses are from 0.125 micrometres to 0.75 micrometres (5 to 30 micro inches) and wherein said tensile elongation properties are generally isotropic in substantially any direction in said plane of said foil.

7. A process for providing an electrodeposited metal foil as claimed in claim 1 comprising:
polishing a plating surface for forming electrodeposited metal foil in a generally random fashion to provide a surface roughness in a longitudinal direction which differs by at most 20% from the surface roughness of said surface in a transverse direction; and
electrodepositing metal onto said plating surface.

8. A process as claimed in claim 7 wherein said polishing step comprises:
subjecting said plating surface to a plurality of sequential polishing steps;
each said polishing step comprising abrading said surface with an abrasive having a particular grit size, wherein succeeding polishing steps utilize an abrasive grit size finer than that used in the previous polishing step.

9. A process as claimed in claim 8 wherein the final polishing step comprises polishing said plating surface using a random motion so as to form a series of randomly oriented scratches in said plating surface.

10. A process as claimed in claim 9 wherein each said polishing step comprises polishing said plating surface using a random motion so as to form a series of randomly oriented scratches in said plating surface, with each succeeding step removing the scratches formed by preceding steps.

11. A process for forming electrodeposited metal foil having substantially isotropic tensile elongation properties, which process comprises:
providing a cell with an electrolyte containing a concentration of metal ions and a first electrode at least partially immersed in said electrolyte;
providing a second electrode having a plating surface;
polishing said plating surface in a generally random fashion to provide a surface roughness in a longitudinal direction which differs by at most 20% from the surface roughness in a transverse direction;
arranging said second electrode in said electrolyte so as to form an interelectrode gap with said first electrode;
moving said plating surface relative to said first electrode;
flowing an electrolyte at a desired flow rate into said interelectrode gap; and
applying a current between said electrodes to form said foil having said substantially isotropic tensile elongation properties.

12. The process of claim 11 which comprises: polishing said substantially isotropic plating surface on said second electrode prior to said arranging step.

13. The process of claim 12 wherein said polishing step comprises:
subjecting said plating surface to a plurality of sequential polishing steps;
each said polishing step comprising abrading said surface with an abrasive having a particular grit size, wherein succeeding polishing steps utilize an abrasive grit size finer than that used in the previous polishing step.

14. The process of claim 13 wherein at least the final polishing step comprises polishing said plating surface using a random motion so as to form a series of randomly oriented scratches in said plating surface.

15. The process of claim 11 wherein each of said polishing steps comprises polishing said plating surface using a random motion so as to form a series of randomly oriented scratches in said plating surface with each succeeding step removing the scratches formed by preceding steps.

16. The process of claim 11 wherein said polishing step comprises polishing said surface so as to form scratch marks in said plating surface which are equally distributed in a first longitudinal direction parallel to the direction of movement of said plating surface and in a second direction transverse to said first direction.

17. A substantially pore free metal foil having substantially isotropic tensile elongation properties formed by the process of claim 11.

18. An apparatus for forming electrodeposited foil having substantially isotropic mechanical properties, comprising:
a tank for holding an electrolyte containing a concentration of metal ions;
a first electrode mounted in said tank so as to be at least partially immersed in said electrolyte;
a second electrode mounted in said tank so as to form an interelectrode gap with said first electrode;
said second electrode having a plating surface with a substantially isotropic surface finish;
means for flowing said electrolyte through said interelectrode gap at a desired flow rate; and
means for applying a current across said electrodes so as to form said foil having said substantially isotropic tensile elongation properties on said plating surface.

19. The apparatus of claim 18 wherein said substantially isotropic surface finish comprises a series of randomly oriented scratch marks in said plating surface.

20. The apparatus of claim 19 wherein:
said plating surface is movable in a first direction; and
said substantially isotropic surface finish comprises a pattern of scratch marks equally distributed in both a direction parallel to said first direction and a direction transverse to said first direction.

21. The apparatus of claim 19 wherein said substantially isotropic surface finish comprises a surface having a surface roughness in a longitudinal direction which differs by at most 20% from the surface roughness in a transverse direction.

22. The apparatus of claim 21 wherein said surface roughness in said longitudinal direction differs by at most 10% from said surface roughness in said transverse direction.

23. The apparatus of claim 21 wherein said surface roughness in said longitudinal direction is from 0.125 micrometres to 0.75 micrometres (5 to 30 micro inches) and wherein said surface roughness in said transverse direction is from 0.125 micrometres to 0.75 micrometres (5 to 30 micro inches).

24. The apparatus of claim 23 wherein said surface roughnesses are from 0.125 micrometres to 0.75 micrometres (5 to 30 micro inches).

## Patentansprüche

1. Elektrolytisch abgeschiedene Metallfolie, die für die Verwendung in elektronischen und elektrischen Anwendungen geeignet ist, wobei diese Folie eine Oberflächenrauhheit auf einer ihrer Hauptoberflächen als Ergebnis ihrer elektrolytischen Abscheidung hat,
dadurch gekennzeichnet, daß die Oberflächenrauhheit in der Längsrichtung der Folie sich um höchstens 20% von der Oberflächenrauhheit in der Querrichtung der Folie unterscheidet und daß die Zugdehnungseigenschaften der Folie im wesentlichen isotrop sind.

2. Metallfolie nach Anspruch 1, die im wesentlichen porenfrei ist

3. Metallfolie nach Anspruch 1 oder 2, die eine Kupferfolie ist, welche für Verwendung in einer gedruckten Schaltung geeignet ist

4. Metallfolie nach Anspruch 1, 2 oder 3, bei der die Oberflächenrauhheit der ersten Oberfläche in der Längsrichtung sich um höchstens 10 % von der Oberflächenrauhheit in der Querrichtung unterscheidet.

5. Metallfolie nach einem der vorausgehenden Ansprüche, bei der die Oberflächenrauhheit der ersten Hauptoberfläche in der Längsrichtung 0,125 Mikrometer bis 0,75 Mikrometer (5 bis 30 Mikro-Inch) beträgt und bei der die Oberflächenrauhheit der ersten Hauptoberfläche in der Querrichtung 0,125 Mikrometer bis 0,75 Mikrometer (5 bis 30 Mikro-Inch) beträgt

6. Metallfolie nach Anspruch 5, bei der die Oberflächenrauhheit 0,125 Mikrometer bis 0,75 Mikrometer (5 bis 30 Mikro-Inch) beträgt und bei der die Zugdehnungseigenschaften allgemein isotrop in im wesentlichen jeder Richtung in der Ebene der Folie sind.

7. Verfahren zur Gewinnung einer elektrolytisch abgeschiedenen Metallfolie nach Anspruch 1, bei dem man eine Metallisierungsoberfläche zur Bildung einer elektrolytisch abgeschiedenen Metallfolie in einer allgemein willkürlichen Weise poliert, um eine Oberflächenrauhheit in einer Längsrichtung zu bekommen, die sich um höchstens 20 % von der Oberflächenrauhheit dieser Oberfläche in einer Querrichtung unterscheidet, und Metall elektrolytisch auf dieser Metallisierungsoberfläche abscheidet.

8. Verfahren nach Anspruch 7, bei dem in der Polierstufe die Metallisierungsoberfläche mehreren aufeinanderfolgenden Polierstufen unterzogen wird, wobei jede dieser Polierstufen ein Abschleifen der Oberfläche mit einem Schleifmittel mit einer speziellen Korngröße umfaßt worin nachfolgende Polierstufen eine feinere Schleifmittel-Korngröße als jene benutzen, die in der vorausgehenden Polierstufe verwendet wurde.

9. Verfahren nach Anspruch 8, bei dem die Endpolierstufe ein Polieren der Metallisierungsoberfläche unter Verwendung einer willkürlichen Bewegung umfaßt, um so eine Reihe willkürlich ausgerichteter Kratzer in der Metallisierungsoberfläche auszubilden.

10. Verfahren nach Anspruch 9, bei dem die Polierstufe ein Polieren der Metallisierungsoberfläche unter Verwendung einer willkürlichen Bewegung umfaßt, um so eine Reihe willkürlich ausgerichteter Kratzer in der Metallisierungsoberfläche auszubilden, wobei jede nachfolgende Stufe die von den vorausgehenden Stufen gebildeten Kratzer entfernt.

11. Verfahren zur Herstellung einer elektrolytisch abgeschiedenen Metallfolie mit im wesentlichen isotropen Zugdehnungseigenschaften, bei dem man:
eine Zelle mit einem Elektrolyten, der eine Metallionenkonzentration enthält, und einer ersten Elektrode, die wenigstens teilweise in diesen Elektrolyten eingetaucht ist, vorsieht,
eine zweite Elektrode mit einer Metallisierungsoberfläche vorsieht,
die Metallisierungsoberfläche in einer allgemein willkürlichen Weise poliert, um eine Oberflächenrauhheit in einer Längsrichtung zu bekommen, die sich höchstens um 20 % von der Oberflächenrauhheit in einer Querrichtung unterscheidet,
die zweite Elektrode in dem Elektrolyten so anordnet, daß mit der ersten Elektrode ein Zwischenelektrodenspalt gebildet wird,
die Metallisierungsoberfläche in Bezug auf die erste Elektrode bewegt,
einen Elektrolyten mit einer erwünschten Fließgeschwindigkeit in den Zwischenelektrodenspalt fließen läßt und
zwischen den Elektroden einen Strom anlegt, um die Folie mit den im wesentlichen isotropen Zugdehnungseigenschaften auszubilden.

12. Verfahren nach Anspruch 11, bei dem man die im wesentlichen isotrope Metallisierungsoberfläche auf der zweiten Elektrode vor dieser Anordnungsstufe poliert.

13. Verfahren nach Anspruch 12, bei dem man in der Polierstufe die Metallisierungsoberfläche mehreren aufeinanderfolgenden Polierstufen unterzieht, wobei jede dieser Polierstufen ein Schleifen der Oberfläche mit einem Schleifmittel mit einer speziellen Korngröße umfaßt, worin nachfolgende Polierstufen eine feinere Schlelfmittelkorngröße als jene benutzen, die in der vorausgehenden Polierstufe verwendet wird.

14. Verfahren nach Anspruch 13, bei dem wenigstens die Endpolierstufe ein Polieren der Metallisierungsoberfläche unter Verwendung einer willkürlichen Bewegung derart, daß eine Reihe willkürlich ausgerichteter Kratzer in der Metallisierungsoberfläche gebildet wird, umfaßt.

15. Verfahren nach Anspruch 11, bei dem jede der Polierstufen ein Polieren der Metallisierungsoberfläche unter Verwendung einer willkürlichen Bewegung umfaßt, um so eine Reihe willkürlich ausgerichteter Kratzer in der Metallisierungsoberfläche auszubilden, wobei jede nachfolgende Stufe die durch vorausgehende Stufen gebildete Kratzer entfernt.

16. Verfahren nach Anspruch 11, bei dem die Polierstufe ein derartiges Polieren der Oberfläche umfaßt, daß Kratzmarkierungen in der Metallisierungsoberfläche ausgebildet werden, die in einer ersten Längsrichtung parallel zu der Bewegungsrichtung der Metallisierungsoberfläche und in einer zweiten Richtung quer zu der ersten Richtung gleich verteilt sind.

17. Im wesentlichen porenfreie Metallfolie mit im wesentlichen isotropen Zugdehnungseigenschaften, die nach dem Verfahren des Anspruches 11 gewonnen wurde.

18. Vorrichtung zur Erzeugung einer elektrolytisch abgeschiedenen Folie mit im wesentlichen isotropen mechanischen Eigenschaften mit:
einem Behälter zum Halten eines eine Metallionenkonzentration enthaltenden Elektrolyten,
einer in dem Behälter derart angeordneten ersten Elektrode, daß sie wenigstens teilweise in den Elektrolyten eintaucht,
einer in dem Behälter derart angeordneten zweiten Elektrode, daß sie mit der ersten Elektrode einen Zwischenelektrodenspalt bildet,
wobei die zweite Elektrode eine Metallisierungsoberfläche mit einer im wesentlichen isotropen Oberflächenausbildung hat,
Einrichtungen, die den Elektrolyten durch den Zwischenelektrodenspalt mit einer erwünschten Fließgeschwindigkeit fließen lassen, und
Einrichtungen zum Anlegen eines Stromes an den Elektroden, um so die Folie mit den im wesentlichen isotropen Zugdehnungseigenschaften auf der Metallisierungsoberfläche auszubilden.

19. Vorrichtung nach Anspruch 18, bei der die im wesentlichen isotrope Oberflächenausbildung eine Reihe willkürlich ausgerichteter Kratzmarkierungen in der Metallisierungsoberfläche umfaßt.

20. Vorrichtung nach Anspruch 19, bei der die Metallisierungsoberfläche in einer ersten Richtung bewegbar ist und die im wesentlichen isotrope Oberflächenausbildung ein Muster von Kratzmarkierungen umfaßt, die sowohl in einer Richtung parallel zu der ersten Richtung als auch in einer Richtung quer zu der ersten Richtung gleich verteilt sind.

21. Vorrichtung nach Anspruch 19, bei der die im wesentlichen isotrope Oberflächenausbildung eine Oberfläche mit einer Oberflächenrauhheit in einer Längsrichtung umfaßt, die sich um höchstens 20 % von der Oberflächenrauhheit in einer Querrichtung unterscheidet.

22. Vorrichtung nach Anspruch 21, bei der die Oberflächenrauhheit in der Längsrichtung sich um höchstens 10 % von der Oberflächenrauhheit in der Querrichtung unterscheidet.

23. Vorrichtung nach Anspruch 21, bei der die Oberflächenrauhheit in der Längsrichtung 0,125 Mikrometer bis 0,75 Mikrometer (5 bis 30 Mikro-Inch) beträgt und bei der die Oberflächenrauhheit in der Querrichtung 0,125 Mikrometer bis 0,75 Mikrometer (5 bis 30 Mikro-Inch) beträgt.

24. Vorrichtung nach Anspruch 23, bei der die Oberflächenrauhheiten 0,125 Mikrometer bis 0,75 Mikrometer (5 bis 30 Mikro-Inch) betragen.

## Revendications

1. Feuille métallique obtenue par électrodéposition appropriée pour être utilisée dans des applications électriques et électroniques, ladite feuille présentant sur l'une de ses surfaces principales une rugosité de surface résultant de l'électrodéposition,
caractérisée en ce que la rugosité de surface dans la direction longitudinale de ladite feuille diffère au plus de 20 % de la rugosité de surface dans la direction transversale de ladite feuille, et en ce que les propriétés d'allongement à la traction de ladite feuille sont sensiblement isotropes.

2. Feuille métallique selon la revendication 1 qui ne présente sensiblement aucun pore.

3. Feuille métallique selon la revendication 1 ou 2, qui est une feuille de cuivre appropriée pour être utilisée sur une carte de circuits imprimés.

4. Feuille métallique selon la revendication 1, 2 ou 3, dans laquelle la rugosité de surface de ladite première surface dans la direction longitudinale diffère au plus 10 % par rapport à la rugosité de surface dans la direction transversale.

5. Feuille métallique selon l'une quelconque des revendications précédentes, dans laquelle la rugosité de surface de ladite première surface principale dans la direction longitudinale est comprise entre 0,125 micromètre et 0,75 micromètre (entre 5 et 30 micropouces) et dans laquelle la rugosité de surface de ladite première surface principale dans la direction transversale est comprise entre 0,125 micromètre et 0,75 micromètre (5 à 30 micropouces).

6. Feuille métallique selon la revendication 5, dans laquelle lesdites rugosités de surface sont comprises entre 0,125 micromètre et 0,75 micromètre (5 à 30 micropouces) et dans laquelle les propriétés d'allongement à la traction sont généralement isotropes sensiblement dans n'importe quelle direction dudit plan de ladite feuille.

7. Procédé pour former une feuille métallique par électrodéposition selon la revendication 1 consistant à :
polir une surface de placage pour former une feuille métallique par électrodéposition de manière généralement aléatoire afin d'obtenir une rugosité de surface dans une direction longitudinale qui diffère d'au plus 20 % par rapport à la rugosité de surface de ladite surface dans la direction transversale ; et
à appliquer par électrodéposition du métal sur ladite surface de placage.

8. Procédé selon la revendication 7, dans lequel ladite étape de polissage consiste à :
soumettre ladite surface de placage à une pluralité d'étapes de polissage séquentielles ;
chacune desdites étapes de polissage comprenant l'abrasion de ladite surface au moyen d'un abrasif ayant une dimension de grains particulière, dans laquelle lesdites étapes successives de polissage utilisent une dimension de grains de l'abrasif plus fine que la dimension utilisée au cours de l'étape précédente de polissage.

9. Procédé selon la revendication 8, dans lequel l'étape finale de polissage comprend un polissage de ladite surface de placage grâce à un mouvement aléatoire de manière à former une série de rayures orientées au hasard sur ladite surface de placage.

10. Procédé selon la revendication 9, dans lequel chacune desdites étapes de polissage consiste en le polissage de ladite surface de placage au moyen d'un mouvement aléatoire afin de former une série de rayures orientées au hasard sur ladite surface de placage, chaque étape suivante consistant à éliminer les rayures formées dans les étapes précédentes.

11. Procédé pour former une couche métallique par électrodéposition ayant des propriétés d'allongement à la traction sensiblement isotropes, lequel procédé consiste à:
installer une cellule avec un électrolyte renfermant une certaine concentration en ions métalliques et une première électrode au moins partiellement immergée dans ledit électrolyte ;
installer une seconde électrode ayant une surface de placage ;
polir ladite surface de placage de manière généralement aléatoire pour créer une rugosité de surface dans une direction longitudinale qui diffère d'au plus 20 % par rapport à la rugosité de surface dans une direction transversale ;
disposer ladite seconde électrode dans ledit électrolyte de façon à former un espace entre les électrodes par rapport à ladite première électrode ;
déplacer ladite surface de placage par rapport à ladite première électrode ;
mettre en circulation un électrolyte avec un débit désiré dans ledit espace entre les électrodes ; et
appliquer un courant entre lesdites électrodes pour former ladite feuille ayant lesdites propriétés d'allongement à la traction sensiblement isotropes.

12. Procédé selon la revendication 11 consistant à :
polir ladite surface de placage sensiblement isotrope sur ladite seconde électrode avant ladite étape d'installation de l'électrode.

13. Procédé selon la revendication 12, dans lequel ladite étape de polissage consiste à :
soumettre ladite surface de placage à une pluralité d'étapes séquentielles de polissage ;
chaque étape de polissage consistant à abraser ladite surface au moyen d'un abrasif dont tes grains ont une dimension particulière, dans laquelle les étapes successives de polissage utilisent une dimension des grains de l'abrasif plus fine que celle de l'abrasif utilisé au cours de l'étape précédente de polissage.

14. Procédé selon la revendication 13, dans lequel au moins l'étape finale de polissage consiste à polir ladite surface de placage grâce à un mouvement aléatoire afin de former une série de rayures orientées au hasard sur ladite surface de placage.

15. Procédé selon la revendication 11, dans lequel chacune desdites étapes de polissage consiste à polir ladite surface de placage au moyen d'un mouvement aléatoire de façon à former une série de rayures orientées au hasard sur ladite surface de placage, chaque étape successive éliminant les rayures formées par les étapes précédentes.

16. Procédé selon la revendication 11, dans lequel ladite étape de polissage consiste à polir ladite surface de façon à former sur ladite surface de placage des marques de rayures qui sont également réparties dans une première direction longitudinale parallèle à la direction du mouvement de ladite surface de placage et dans une seconde direction perpendiculaire à ladite première direction.

17. Feuille métallique ne présentant sensiblement aucun pore, ayant sensiblement des propriétés isotropes d'allongement à la traction, et formée par le procédé de la revendication 11.

18. Appareil pour former par électrodéposition une feuille ayant sensiblement des propriétés mécaniques isotropes, comprenant :
une cuve pour contenir un électrolyte renfermant une certaine concentration en ions métalliques ;
une première électrode montée dans ladite cuve de manière à être au moins partiellement immergée dans ledit électrolyte ;
une seconde électrode montée dans ladite cuve de manière à former un espace entre les électrodes par rapport à ladite première électrode ;
ladite seconde électrode ayant une surface de placage avec une finition de surface sensiblement isotrope ;
un moyen pour faire circuler ledit électrolyte dans ledit espace entre les électrodes avec un débit souhaité ; et
un moyen pour appliquer un courant aux bornes desdites électrodes afin de former ladite feuille qui a des propriétés d'allongement à la traction sensiblement isotropes sur ladite surface de placage.

19. Appareil selon la revendication 18, dans lequel ladite finition de surface sensiblement isotrope comprend une série de marques de rayures orientées au hasard sur ladite surface de placage.

20. Appareil selon la revendication 19, dans lequel :
ladite surface de placage est mobile dans une première direction ; et
ladite finition de surface sensiblement isotrope comprend une configuration de marques de rayures également réparties à la fois dans une direction parallèle à ladite première direction et dans une direction perpendiculaire à ladite première direction.

21. Appareil selon la revendication 19, dans lequel ladite finition de surface sensiblement isotrope comprend une surface ayant une rugosité de surface dans une direction longitudinale qui diffère d'au plus 20 % par rapport à la rugosité de surface dans une direction transversale.

22. Appareil selon la revendication 21, dans lequel ladite rugosité de surface dans ladite direction longitudinale diffère d'au plus 10 % par rapport à ladite rugosité de surface dans ladite direction transversale.

23. Appareil selon la revendication 21, dans lequel ladite rugosité de surface dans ladite direction longitudinale est comprise entre 0,125 micromètre et 0,75 micromètre (5 à 30 micropouces) et dans lequel ladite rugosité de surface dans ladite direction transversale varie entre 0,125 micromètre et 0,75 micromètre (5 à 30 micropouces).

24. Appareil selon la revendication 23 dans lequel lesdites rugosités de surface varient entre 0,125 micromètre et 0,75 micromètre (5 à 30 micropouces).
